# EUROPEAN PATENT APPLICATION

(11) **EP 3 748 695 A1**
(43) Date of publication of application: **09.12.2020**
(21) Application number: 19305736.1
(22) Date of filing: 07.06.2019
(51) Int. Cl.: H01L 31/0236, H01L 21/3065, H01L 21/205, C23C 16/24, C30B 29/06, H01L 21/67, C23C 16/44, H01J 37/32, C30B 33/12, C23C 16/56

(54) **METHOD FOR TEXTURING THE SURFACE OF A CRYSTALLINE SILICON LAYER AND ASSOCIATED REACTION CHAMBER**

(71) Applicant: TOTAL SE, 92400 Courbevoie (FR); Centre National de la Recherche Scientifique, 75016 Paris (FR); Electricité de France, 75008 Paris (FR); Institut Photovoltaique d'Ile de France, 91120 Palaiseau (FR); L'AIR LIQUIDE, SOCIETE ANONYME POUR L'ETUDE ET L'EXPLOITATION DES PROCEDES GEORGES CLAUDE, 75007 Paris (FR); Ecole Polytechnique, 91120 Palaiseau (FR)
(72) Inventor: ROCA I CABARROCAS, Pere, 91140 VILLEBON SUR YVETTE (FR); JOHNSON, Erik, 92310 SEVRES (FR); CHEN, Wanghua, Zhejiang province China 315211 (FR)
(74) Representative: Croonenbroek, Thomas Jakob

(57) **Abstract**

The present invention refers to a method for texturing a crystalline silicon layer (7), the said method comprising the following steps:
- providing (101) a reaction chamber (1) configured for reactive plasma processing with at least one wall element covered with a material resistant to hydrogen plasma (3),
- providing (102) a crystalline silicon layer (7) comprising a surface layer (7a) containing embedded cones and/or inverse pyramids of amorphous silicon corresponding to epitaxial breakdown regions (7b),
- placing (103) the provided layer (7) in the provided reaction chamber (1),
- applying (105) hydrogen plasma etching on the provided layer (7) placed in the provided reaction chamber (1) to remove at least partially the amorphous portions (7b) of the crystalline silicon layer (7) corresponding to the epitaxial breakdown regions, and thus obtaining a texturing of the crystalline silicon layer (7).

(Figure 3)

## Description

### Background of the invention

The embodiment(s) in the following description are only to be considered as examples. Although the description refers to one or several embodiments, this does not mean inevitably that every reference concerns the same embodiment, or that the characteristics apply only to a single embodiment. Simple characteristics of various embodiments can be also combined to new embodiments that are not explicitly described.
The present invention refers to the texturing of a crystalline silicon surface layer of a photovoltaic cell, said texturing enabling diffusion and trapping of the incident light within the photovoltaic cell so that the reflection is reduced and the efficiency of the photovoltaic cell is improved.

To optimize the trapping of the incident light, the desired texturing corresponds to the formation of inverted pyramids or inverted cones having a diameter of a few hundreds of nanometers.

Different techniques are known in the state of the art to produce such texturing, such as optical lithography, which produces the ideal morphology of regularly spaced inverted pyramids or cones but is too expensive for the photovoltaic industry as it requires the application of a mask. A variant of this technique is nanoimprint lithography, which can also produce a variety of morphologies. A second technique is maskless wet etching, which is less expensive but results in a less optimal and random set of pyramids. A third technique, namely plasma nano-texturing of the surface resulting in silicon cones with very high aspect ratios, can produce non-reflective surfaces ("black silicon") but is notoriously difficult to passivate afterwards. A variant of this technique includes the use of plasma etching to directly etch craters in crystalline silicon, which are easier to passivate but are less effective for light trapping at shorter wavelengths.

It is therefore a goal of the present invention to provide a solution to produce the optimal inverted pyramid/cone by selectively removing parts of a silicon crystalline layer without employing lithography and therefore providing the opportunity for a lower cost.

The present invention aims therefore at providing a solution to obtain a texturing the surface of a photovoltaic cell made of crystalline silicon at a limited manufacturing cost.

### Summary of the invention

The present invention refers to a method for texturing a crystalline silicon layer of a photovoltaic cell, the said method comprising the following steps:
- providing a reaction chamber configured for reactive plasma processing with at least one wall element covered with a material resistant to hydrogen plasma,
- providing a crystalline silicon layer comprising a surface layer containing embedded inverse cones and/or inverse pyramids of amorphous silicon corresponding to epitaxial breakdown regions,
- placing the provided layer in the provided reaction chamber,
- applying hydrogen plasma etching on the provided layer placed in the provided reaction chamber to remove at least partially the amorphous portions of the crystalline silicon layer corresponding to the epitaxial breakdown regions, and thus obtaining a texturing of the crystalline silicon layer.

According to another aspect of the invention, the at least one wall element corresponds to at least a portion of the inner walls of the reaction chamber, in particular the entirety of the inner walls.

According to a further aspect of the invention, the material resistant to hydrogen plasma is silicon oxide or silicon nitride.

According to an additional aspect of the invention, the covering of the at least one wall element with a material resistant to hydrogen plasma is made by a continuous layer of at least 10 nm of material resistant to hydrogen plasma.

According to another aspect of the invention, the covering of the at least one wall element with a material resistant to hydrogen plasma is obtained by a deposition step among one of the following techniques:
- a Chemical Vapor Deposition "CVD" or,
- a Plasma-Enhanced Chemical Vapor Deposition "PECVD" or,
- a Metal Organic Chemical Vapour Deposition "MOCVD".

According to a further aspect of the invention, the step of providing a crystalline silicon layer with a surface containing inverse amorphous silicon cones or pyramids results from the epitaxial growth of the crystalline silicon layer under conditions of partial epitaxial breakdown wherein epitaxial growth occurs on a crystalline surface but amorphous growth occurs on an amorphous surface, resulting in said cones or pyramids of amorphous silicon.
Such condition may be obtained for example by using the following parameters during the step of hydrogen plasma etching:
- a hydrogen flow rate and pressure chosen so that the gas residence time in the chamber is comprised between 0.05 and 1 second. For example 500 sccm for a reaction chamber of 300 cm³ at 2 Torr. A Torr corresponds to 133 Pa.
- a power injected to the plasma via a radio-frequency source resulting in a volumetric power density comprised between 0.02 and 0.5 W/cm3. For example, 50 W for a hydrogen flow rate of 500 sccm for a reaction chamber of 300 cm³ at 2 torr,
- an ion bombardment energy lower than 70 eV.

According to a further aspect of the invention, the epitaxial growth is achieved at a temperature lower than 800°C.

According to an additional aspect of the invention, the epitaxial growth is obtained by Plasma-Enhanced Chemical Vapor Deposition "PECVD" with a temperature higher than 150°, preferably around 400 °C.

According to another aspect of the invention, the pressure is comprised between 2 Torrs (i.e. 266 Pa) and 4 Torrs (i.e. 533 Pa), preferably between 2,3 Torrs (i.e 307 Pa) and 3,2 Torrs (i.e. 427 Pa).

According to another aspect of the invention, the epitaxial conditions are chosen such that epitaxial growth occurs on a crystalline substrate, but amorphous growth occurs on a non-crystalline substrate (such as glass).

According to a further aspect of the invention, at least one of the following parameters is modified during the epitaxial growth to produce epitaxial breakdown :
- the ion bombardment energy,
- the power injected in the plasma,
- the pressure,
- the gas composition,
- the temperature.

According to an additional aspect of the invention, the at least one parameter is modified during a duration shorter than or equal to ten times the gas residence time.

The present invention also refers to a reaction chamber configured for carrying out a method for texturing a crystalline silicon layer of a photovoltaic cell as described above wherein the said reaction chamber comprises at least one wall element covered with a material resistant to hydrogen plasma.

### Brief description of the drawings

[Fig.1] is a flowchart of the different steps of the method according to the invention;
[Fig.2] is a diagram of a reaction chamber according to an embodiment of the present invention;
[Fig.3] is a diagram of the a crystalline silicon substrate comprising a layer of crystalline silicon with embedded inverse cones of amorphous silicon;
[Fig.4] is an upper view of a silicon substrate with embedded inverse cones of amorphous silicon;
[Fig.5] is a cross-sectional view of a silicon substrate with embedded inverse cones of amorphous silicon;
[Fig.6] is a diagram of the application of a silicon tetrafluoride SiF₄ plasma on a silicon substrate within a reaction chamber;
[Fig. 7] is a diagram of the application of a hydrogen H₂ plasma on a silicon substrate within a reaction chamber;
[Fig.8] is a diagram of the silicon substrate of fig.3 after application of hydrogen plasma etching;

### Detailed description of the invention

The present invention refers to a method for texturing a crystalline silicon layer of a photovoltaic cell in order to minimize the amount of light which is reflected by the surface of the photovoltaic cell.

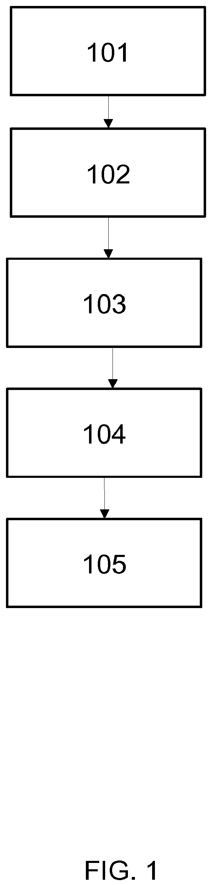

Fig.1 represents a flow chart of the different steps of the present method. The order of some steps may differ from the following order.

The first step 101 refers to the provision of a reaction chamber configured for chemical vapor deposition with at least one wall element covered with a material resistant to hydrogen plasma and having a low recombination rate for atomic hydrogen. Preferably, all the inner walls of the reaction chamber are covered by such material resistant to hydrogen plasma. The goal of the coating is to provide a passivation of the inner walls in order to prevent them from interacting with the hydrogen or other gas used during the following etching step so that there is no re-deposition of micro/nanocrystalline silicon.

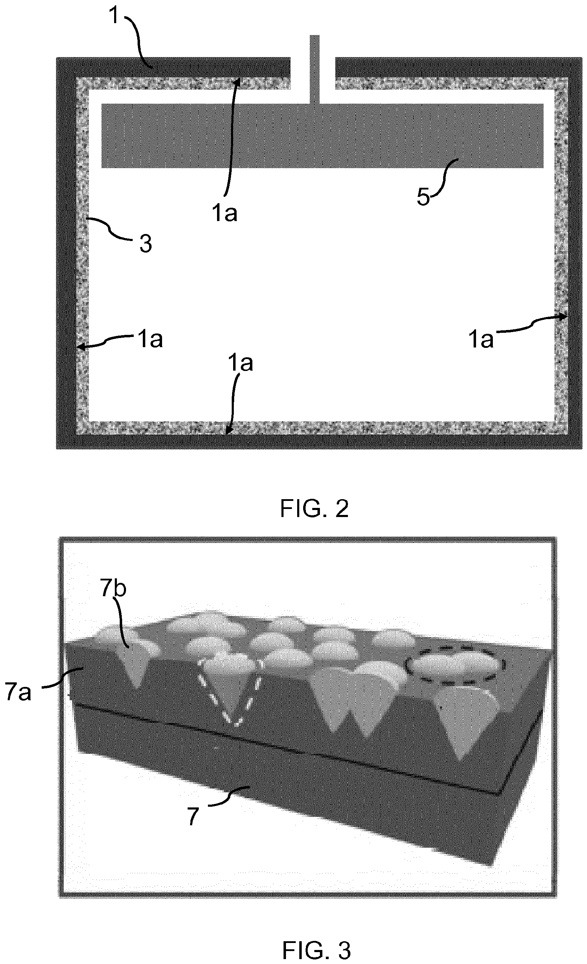

Fig.2 represents an example of a deposition step that may be applied to obtain such reaction chamber 1. In this example, the material resistant to hydrogen plasma is silicon oxide (SiOₓ) but other material such as silicon nitride may also be used. A mixture comprising a plurality of gas: H₂, CO₂ and SiH₄ is introduced in the reaction chamber 1 and a radio-frequency electrode 5 supplying 13,56 MHz waves is used to obtain an SiOₓ coating 3 on the inner walls 1a of the reaction chamber 1. Different techniques may be used to obtain such coating such as Chemical Vapor Deposition "CVD" or Plasma-Enhanced Chemical Vapor Deposition "PECVD" or Metal Organic Chemical Vapour Deposition "MOCVD".

The coating 3 may also be applied only on some portions of the inner walls 1a. The thickness of the coating is for example of at least 10nm, more particularly at least 100 nm, and is preferably uniform over the entire area of the reactor walls being coated. In the case of a reaction chamber 1 dedicated to the application of hydrogen plasma etching, a coating 3 having a large thickness may be applied and used several times for the texturing of several silicon wafer samples.

The second step 102 refers to the provision of a crystalline silicon layer comprising a surface layer containing embedded inverse cones and/or inverse pyramids of amorphous silicon. The said portions of amorphous silicon correspond to regions of epitaxial breakdown.

To obtain such layer, an epitaxial growth from a crystalline silicon substrate may be achieved, the said epitaxial growth undergoing partial and localized epitaxial breakdown, leading to the formation of amorphous silicon portions having inverted cone or inverted pyramid shape. The epitaxial growth may be obtained by one of the following techniques:
- a Chemical Vapor Deposition "CVD" technique or,
- a Plasma-Enhanced Chemical Vapor Deposition "PECVD" technique or,
- a Metal Organic Chemical Vapour Deposition "MOCVD" technique.

Such regions of epitaxial breakdown may be obtained by changing at least one of the following influence parameters during the epitaxial growth: the ion bombardment energy or the power injected in the plasma or the pressure or the gas composition or the temperature. Indeed, these parameters need to be set within predetermined ranges of values to obtain the epitaxial growth so that a change of value of at least one of these parameters, even during a short duration such as one second or even shorter, may lead to the creation of localized regions of epitaxial breakdown leading to the formation of hydrogenated amorphous silicon areas. Such localized zones of epitaxial breakdown may also be obtained when the parameters are set to values close to the borderline of the epitaxial growth zone defined by the different ranges of values of the different influence parameters. In these conditions of partial epitaxial breakdown, epitaxial growth occurs on a crystalline surface but amorphous growth occurs on an amorphous surface resulting therefore to the cones or pyramids of amorphous silicon.

In order to obtain epitaxial growth conditions with the possibility of localized breakdown events, the following ranges of values may be chosen:
- a temperature lower than 800°C, in particular in a range between 150 and 400°C, preferably close to 400°C,
- a pressure lower than 4 Torr and higher than 2 Torr, for example in a range between 2,3 and 3,2 Torr wherein a Torr corresponds to 133 Pa.
- a gas mixture comprising hydrogen diluted silane
- deposition conditions such that epitaxial growth occurs on a crystalline surface, whereas amorphous growth (and not microcrystalline or nanocrystalline growth) occurs on an amorphous surface.

As indicated previously, at least one of these parameters, for example the ion bombardment energy, may be changed (during a predetermined duration, for example one second) during the epitaxial growth to ensure the formation of localized regions of epitaxial breakdown. The time for which a parameter may be changed must be such that it is significant relative to the gas-residence time in the reactor.

Fig.3 represents a sectional and perspective view of a silicon substrate 7 with a layer 7a obtained by epitaxial growth with regions of epitaxial breakdown 7b having the shape of inverted cones.

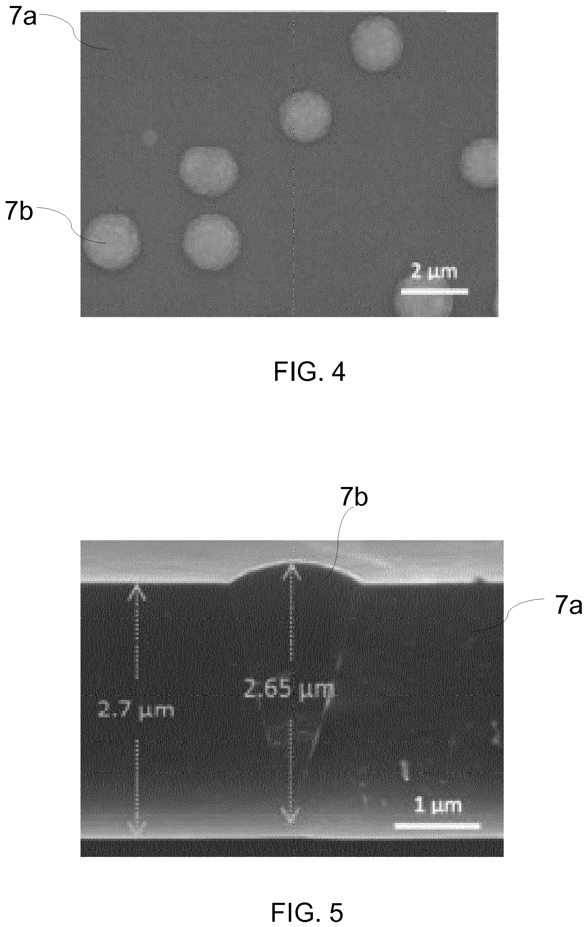

Fig.4 represents an upper view of a silicon substrate 7 comprising regions of epitaxial breakdown 7b and fig.5 represents a sectional view of such silicon substrate 7 wherein examples of height and diameter dimensions of the localized epitaxial breakdown regions 7b having a conical shape are given. The diameter may be comprised between 0,5 and 3 µm and the height corresponds to 1,5 to 4 times the value of the diameter of the inverted cones.

The reaction chamber 1 used for the epitaxial growth may be the same as the reaction chamber provided in step 101. In such case the coating described in step 101 is achieved after the epitaxial growth of step 102.

The third step 103 refers to the placement of the silicon layer 7 provided in the second step 102 in the reaction chamber 1 provided in the first step 101 or possibly in the third step 103.

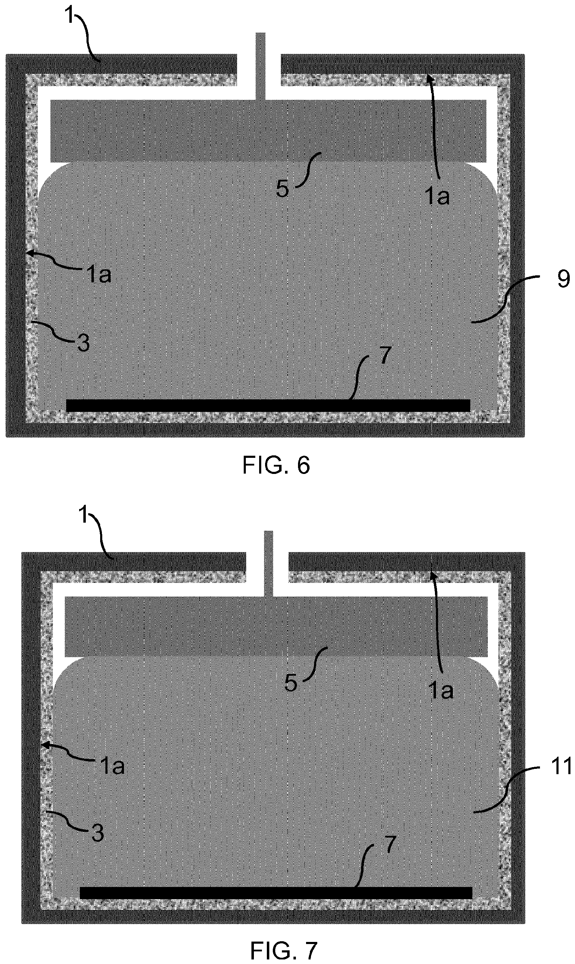

The fourth step 104 is an optional step and refers to the application of a silicon tetrafluoride SiF4 plasma 9 (or another-oxide removing plasma) within the reaction chamber 1 for removing possible native oxide on the epitaxially grown silicon layer 7. Fig.6 represents such application of silicon tetrafluoride SiF4 plasma 9.

The fifth step 105 refers to the application of hydrogen plasma etching on the provided layer 7 placed in the provided reaction chamber 1 to remove at least partially the amorphous portions 7b having inverted cone or inverted pyramid shapes and corresponding to the epitaxial breakdown regions from the silicon layer 7a. Fig.7 represents such application of hydrogen plasma 11. Indeed, due to the high etching selectivity of the hydrogen plasma 11, it is possible to selectively remove the portions 7b of hydrogenated amorphous silicon without removing the crystalline silicon portions 7a. Such etching is also possible due to the coating 3 of inner walls 1a of the reaction chamber 1 to prevent reaction between the inner walls 1a of the reaction chamber 1 and the hydrogen plasma 11. Furthermore, it has to be noted that the removal of the amorphous portions 7b may be only a partial removal.

During the hydrogen plasma etching, the different parameters may be selected according to the following requirements:
- the hydrogen flow rate and pressure may be chosen so that the gas residence time in the chamber is comprised between 0.05 and 1 second,
- the power injected to the plasma via a radio-frequency source may be chosen so that a volumetric power density comprised between 0.02 and 0.5 W/cm3 is obtained and,
- the ion bombardment energy may be chosen to be lower than 70 eV.

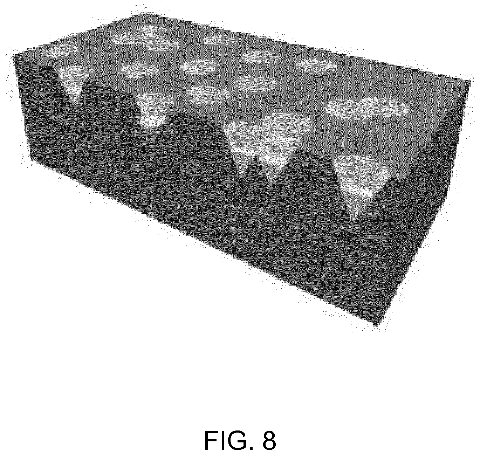

Fig.8 represents a perspective and sectional view of the substrate of fig.3 after application of the hydrogen plasma etching.

Thus, due to the use reaction chamber 1 with a pre-coating 3 resistant to hydrogen plasma, the present method enables a selective etching between amorphous 7b and crystalline 7a silicon portions of a layer 7 enabling therefore a texturing of a crystalline silicon layer efficient for light-trapping surface of a photovoltaic cell without requiring expensive techniques such as lithography.

The present invention also refers to a reaction chamber 1 configured for carrying out a method for texturing a crystalline silicon layer of a photovoltaic cell as described previously wherein the said reaction chamber 1 comprises at least one wall element covered with a coating 3 resistant to hydrogen plasma 11. Such coating 3 may be made of silicon oxide (SiOₓ) or silicon nitride and may be apply by Chemical Vapor Deposition "CVD" or Plasma-Enhanced Chemical Vapor Deposition "PECVD" or Metal Organic Chemical Vapour Deposition "MOCVD".

## Claims

1. Method for texturing a crystalline silicon layer (7), notably of a photovoltaic cell, the said method comprising the following steps:
- providing (101) a reaction chamber (1) configured for reactive plasma processing with at least one wall element covered with a material (3) resistant to hydrogen plasma (11),
- providing (102) a crystalline silicon layer (7) comprising a surface layer (7a) containing embedded inverse cones and/or inverse pyramids of amorphous silicon corresponding to epitaxial breakdown regions (7b),
- placing (103) the provided layer (7) in the provided reaction chamber (1),
- applying (105) hydrogen plasma (11) etching on the provided layer (7) placed in the provided reaction chamber (1) to remove at least partially the amorphous portions (7b) of the crystalline silicon layer (7) corresponding to the epitaxial breakdown regions, and thus obtaining a texturing of the crystalline silicon layer (7).

2. Method in accordance with the previous claim wherein the at least one wall element corresponds to at least a portion of the inner walls (1a) of the reaction chamber (1), in particular the entirety of the inner walls (1a).

3. Method in accordance with one of the previous claims wherein the material (3) resistant to hydrogen plasma (11) is silicon oxide or silicon nitride.

4. Method in accordance with one of the previous claims wherein the covering of the at least one wall element (1a) with a material (3) resistant to hydrogen plasma (11) is made by a continuous layer having a thickness of at least 10 nm of material resistant to hydrogen plasma (11).

5. Method in accordance with one of the previous claims wherein the covering of the at least one wall element with a material (3) resistant to hydrogen plasma (11) is obtained by a deposition step among one of the following techniques:
- a Chemical Vapor Deposition "CVD" or,
- a Plasma-Enhanced Chemical Vapor Deposition "PECVD" or,
- a Metal Organic Chemical Vapour Deposition "MOCVD".

6. Method in accordance with one of the previous claims wherein the step of hydrogen plasma (11) etching (105) comprises:
- a hydrogen flow rate and pressure chosen so that the gas residence time in the chamber is comprised between 0.05 and 1 second,
- a power injected to the plasma via a radio-frequency source resulting in a volumetric power density comprised between 0.02 and 0.5 W/cm3 and,
- an ion bombardment energy lower than 70 eV.

7. Method in accordance with one of the previous claims wherein the step of providing a crystalline silicon layer (102) with a surface containing inverse amorphous silicon cones or pyramids results from the epitaxial growth of the crystalline silicon layer under conditions of partial epitaxial breakdown, resulting in said cones or pyramids of amorphous silicon.

8. Method in accordance with claim 7 wherein the epitaxial growth is achieved at a temperature lower than 800°C.

9. Method in accordance with the previous claim wherein the epitaxial growth is obtained by Plasma-Enhanced Chemical Vapor Deposition "PECVD" and wherein the temperature is higher than 150°, preferably around 400 °C.

10. Method in accordance with one of the claims 7 to 9 wherein the pressure is comprised between 2 Torrs corresponding to 266 Pa and 4 Torrs corresponding to 533 Pa, preferably between 2,3 Torrs correspoding to 306 Pa and 3,2 Torrs corresponding to 427 Pa.

11. Method in accordance with one of the claims 7 to 10 wherein at least one of the following parameters is modified during the epitaxial growth to produce epitaxial breakdown :
- the ion bombardment energy,
- the power injected in the plasma,
- the pressure,
- the gas composition,
- the temperature.

12. Method in accordance with the previous claim wherein the at least one parameter is modified during a duration shorter than or equal to ten times the gas residence time.

13. Reaction chamber (1) configured for carrying out a method for texturing a crystalline silicon layer of a photovoltaic cell according to one of the previous claims wherein the said reaction chamber (1) comprises at least one wall element covered with a material (3) resistant to hydrogen plasma (11).
